# EUROPEAN PATENT APPLICATION

(11) **EP 0 670 501 A1**
(43) Date of publication of application: **06.09.1995**
(21) Application number: 95301360.4
(22) Date of filing: 02.03.1995
(51) Int. Cl.: G01R 33/06, G11B 5/33

(54) **Magnetic transducer**

(30) Priority: 04.03.1994 US 206536
(71) Applicant: SEAGATE TECHNOLOGY INTERNATIONAL, Georgetown Grand Cayman Island (KY)
(72) Inventor: Henderson, Michael R., Egan, Minnesota 55112 (US); Amin, Nurul, CR Burnville, Minnesota 55337 (US); Ryan, Patrick J., St Paul, Minnesota 55116 (US); Grunwald, William C., Apple Valley, Minnesota 55124 (US)
(74) Representative: Sturt, Clifford Mark

(57) **Abstract**

A transducer (22) converts a magnetic signal into an electric signal. The transducer comprises a first magnetic material (62) in contact with a non-ferromagnetic material (56), which is further in contact with a second ferromagnetic material (52). A current is forced through the second ferromagnetic material (52) into the non-ferromagnetic material (56). A magnetic field from a magnetic source determines the magnetic moment of the first ferromagnetic material (62). The magnetic moment of the second ferromagnetic material (52) is constant. A change in the direction of the magnetic signal from the magnetic source creates a change in an electrical value between the first ferromagnetic (62) material and the non-ferromagnetic material (56). This electrical value is sensed by a sensing means (34) which creates an electrical signal based on that value.

## Description

The present invention relates to a magnetic transducer. The transducer may be used for sensing information recorded on magnetic storage media.

In an atom, electrons reside in energy states. Each state is defined by a unique combination of the four quantum numbers n, 1, m, and s. Electrons in an atom can only have an amount of energy corresponding to one of these energy states. The electrons do not have energy values between the energy states. Each electron has a unique set of quantum numbers distinct from all other electrons in the atom. In addition, the electrons of an atom will, for the most part, occupy the lowest energy states first and progressively fill higher energy states.

In materials, these energy states broaden into discrete energy bands. The electrons fill these bands by first entering the lowest energy state within a band and then progressively filling incrementally higher energy states within the band. Once a band is filled, electrons generally begin to fill the lowest energy states in the next higher energy band. Where the energy level of separate bands overlap, electrons fill both bands simultaneously.

As with the atom, the energy bands in materials are determined by the four quantum numbers. In general, each new combination of quantum numbers creates a new energy band. Since the quantum number "s" has two values for any given combination of n, m, and 1, there should be two energy bands for each such combination of n, m, and 1. These two energy bands are referred to as the spin up and spin down energy bands. Within the spin up energy band, all of the electrons have the same +1/2 value for s. Within the spin down energy band, all of the electrons have a -1/2 value for s.

In most materials, the spin up energy band and the spin down energy band are at the same energy level and thus fill with electrons to the same point. This produces an equal number of spin up and spin down electrons in the material. However, in ferromagnets, the energy band for one spin direction is lower than the energy band for the other spin direction. This means that in ferromagnetic materials, the electrons fill the energy band of one spin direction before filling the energy band of the other spin direction. This causes a spin imbalance because there are more electrons with one type of spin than the other.

This spin imbalance in ferromagnetic materials allows the materials to generate magnetic fields without the presence of an external magnetic field. The ability of a material to create a magnetic field is characterized as its magnetic moment. Each small part of a block of material has its own magnetic moment and the block as a whole has an aggregate magnetic moment based upon the vector summing of the individual magnetic moments. Both types of magnetic moments have a direction and intensity indicative of the direction and intensity of the magnetic field created by the material.

Some ferromagnets also exhibit single domain magnetism. Single domain magnetism occurs when each individual magnetic moment in the block points in the same direction as all of the other individual magnetic moments. The direction of the individual moments in such a ferromagnet may be changed by exposing the ferromagnet to an external magnetic field. If the field is strong enough, all of the magnetic moments of the entire ferromagnet will switch to match the direction of the external magnetic field. The strength of the magnetic field needed to switch the magnetic moments of the ferromagnet is known as the coercivity of the ferromagnet. Different ferromagnetic materials have different coercivities.

Once the magnetic moments for the ferromagnet have been changed to match the external field, they will retain that magnetic moment even after the magnetic field is removed. In fact, the magnetic moment of the ferromagnet will not change again until a significant external magnetic field of a different direction is applied to the ferromagnet.

When a ferromagnet is placed next to a non-ferromagnet and a current is forced through the ferromagnet and into the non-ferromagnet, the current is carried by electrons from the highest energy band in the ferromagnet. Since the energy bands for the two types of spin are separated in the ferromagnet, the conducting electrons are made up almost entirely of the electrons of one spin.

Since the conducting electrons all have the same spin, the non-ferromagnet receives only electrons with that spin. To ensure charge neutrality the non-ferromagnet must also release electrons. However, the released electrons do not all have the same spin. Thus, the number of electrons with a spin that matches the upper energy band of the ferromagnetic material increases in the non-ferromagnetic material. In addition, the number of electrons with the opposite spin decreases in the non-ferromagnetic material. As a result, the non-ferromagnetic material is transformed from having an equal number of spin up and spin down electrons to having more electrons with one spin direction than electrons with the other spin direction. This creates a spin imbalance in the non-ferromagnet.

This imbalance can be sensed by a second ferromagnet placed next to the non-ferromagnetic material. This second ferromagnetic material has filled the energy band for one spin direction but has not filled the energy band for the other spin direction. Since electrons may not enter occupied states, the second ferromagnet is capable of receiving only electrons with one spin direction. If the spin direction of the electrons it can accept matches the spin of the electrons injected into the non-ferromagnetic material, the injected electrons will be attracted to the second ferromagnet. If the spin direction of the electrons it can accept does not match the injected electrons, the injected electrons will not be attracted to the second ferromagnet.

The electron's attraction to the second ferromagnet will cause a current to flow between the two materials if a complete circuit with low impedance is created. If a high impedance circuit is used, a potential will develop between the non-ferromagnet and the second ferromagnet. If the electrons are not attracted to the second ferromagnet there will be a very small current or potential.

Mark Johnson and R.H. Silsbee have measured this effect at very cold temperatures, on the order of 65°K. However, Johnson and Silsby have not used this device at warmer temperatures. See M. Johnson and R.H. Silsbee, Phys. Rev. B, volume 37, 5326 (1988). Using such a device at higher temperatures presents several problems. The increased temperature increases the number of spin up and spin down electrons entering the non-ferromagnet. This reduces the size of the imbalance in the non-ferromagnet. Further, the increased temperature increases the number of events capable of converting the spin of electrons in the non-ferromagnet. Such conversions further reduce the imbalance in the non-ferromagnet. Thus, increased temperature degrades the physical event measured by the sensing ferromagnet. In addition, Johnson and Silsby have never used this device as a magnetic transducer for converting magnetic signals into electrical signals.

Magnetic transducers sense a magnetic signal and create an electrical signal based on the magnetic signal. Magnetic transducers have been used in the field of magnetic recording to read localized magnetic fields from a magnetic surface and translate the localized magnetic fields into electrical signals.

Early magnetic transducers were based upon induction. Induction is the creation of an electrical current in an electrical conductor by a change in magnetic flux through the conductor. The direction of the current indicates the direction of change of the magnetic field and the magnitude of the current correlates to the rate of change of the magnetic field. The magnetic fields associated with magnetic recording do not have linear spacial variations. Therefore, the current induced in inductive transducers is not digital but analog.

A second type of transducer is a magnetoresistive head. Magnetoresistive heads operate by measuring changes in the resistance of materials as they move through different magnetic fields. Like inductive transducers, magnetoresistive heads are analog devices. The amount of change in the resistivity is dependent on the field strength of the magnetic field. Since the field strength varies in an analog manner, the resistivity varies in an analog manner.

According to one aspect of the present invention, there is provided a transducer comprising ferromagnetic material and non-ferromagnetic material, characterised in that the transducer is arranged such that it senses information on a storage medium by using a magnetic non-equilibrium caused by current flow between ferromagnetic material and non-ferromagnetic material. According to another aspect of the present invention, there is provided a transducer for converting a magnetic signal into an electric signal, the transducer characterised by comprising: a first ferromagnetic material having a magnetic moment with a direction; a non-ferromagnetic material, having a first side and a second side, the first side coupled to the first ferromagnetic material; a second ferromagnetic material coupled to the second side of the non-ferromagnetic material, the second ferromagnetic material having a magnetic moment; injection means, coupled to the second ferromagnetic material and the non-ferromagnetic material for injecting electrons from the second ferromagnetic material into the non-ferromagnetic material; and sensing means, coupled to the non-ferromagnetic material and the first ferromagnetic material for sensing the direction of the magnetic moment of the first ferromagnetic material caused by a magnetic signal provided by a magnetic source proximate to the first ferromagnetic material, and creating an electrical signal based on that direction.

The first side of the non-ferromagnetic material may be in direct contact with the first ferromagnetic material.

The second side of the non-ferromagnetic material may be in contact with the second ferromagnetic material.

According to a further aspect of the invention, there is provided an apparatus for converting a magnetic signal into an electric signal, the apparatus characterised by comprising: an injection material, accepting electrons without uniform quantum spin values but releasing electrons with uniform quantum spin values; a storage material, coupled to the injection material, the storage material receiving electrons with uniform quantum spin values from the injection material, but releasing electrons without uniform quantum spin values, the exchange of electrons creating a magnetic imbalance in the storage material; a sensing material, coupled to the storage material but separated from the injection material, the sensing material residing within the magnetic signal, the sensing material's ability to accept electrons from the storage material changing with changes in the direction of the magnetic signal; injection means coupled to the injection material and the storage material for injecting electrons into the injection material and accepting electrons from the storage material; and sensing means coupled to the storage material and the injection material for sensing the changes in the sensing material's ability to accept electrons from the storage material.

The storage material may be in contact with the injection material.

The sensing material may be in contact with the storage material.

The magnetic signal may originate from a magnetic disk or a computer disk drive.

The magnetic imbalance in the storage material may spatially decay away from the injection material.

The apparatus may further comprise a first insulating material between the injection material and the storage material, the first insulating material having at least one opening and preventing electron flow between the injection material and the storage material except through an opening.

The apparatus may further comprise a second insulating material between the storage material and the sensing material, the second insulating material having at least one opening and preventing electron flow between the storage material and the sensing material except through an opening.

The apparatus may be such that the storage material is coupled to the sensing means through a ground sample made of the same material as the storage material, the ground sample separated from the storage material by the second insulating material except at an opening in the second insulating material, the magnetic imbalance in the storage material at the ground sample being equal to the magnetic imbalance in the storage material at the sensing material.

According to another aspect of the invention, there is provided a magnetic field sensor, for sensing an external magnetic field, the magnetic field sensor characterised by comprising: spin injection means, producing electrons with quantum spin values which are substantially in one direction; and sensing means, coupled to the spin injection means and having electrons injected into it by the spin injection means, the sensing means responding to the external magnetic field and the direction of the quantum spin of the injected electrons to produce an electrical signal.

The spin injection means of the magnetic field sensor may further comprise a ferromagnetic material, coupled to the sensing means, having an aggregate magnetic moment with a direction and accepting electrons without uniform quantum spin values but releasing electrons with quantum spin values of substantially only the opposite direction from the direct of the aggregate magnetic moment; and an electron source, coupled from the ferromagnetic material and the sensing means, the electron source forcing electrons with non-uniform quantum spin values into the ferromagnetic material and forcing the ferromagnetic material to release electrons into the sensing means.

The sensing means of the magnetic field sensor may further comprise a non-ferromagnetic material, coupled to the spin injection means, the non-ferromagnetic material being injected with electrons with uniform quantum spin values; a ferromagnetic sensor material, connected directly to the non-ferromagnetic material and having an aggregate magnetic moment which is determined by the external magnetic field and which controls the ferromagnetic sensor material's ability to accept electrons from the non-ferromagnetic material; and a sensing circuit, having two ends, the first end coupled to the non-ferromagnetic material and the second end coupled to the ferromagnetic sensor material, the sensing circuit electrically sensing the ferromagnetic sensor material's ability to accept electrons from the non-ferromagnetic material.

The magnetic field being sensed by the magnetic field sensor may be produced by a pole used to transmit magnetic flux from a medium.

In one aspect, the present invention is a magnetic transducer for converting magnetic signals into electrical signals. The transducer may comprise a non-ferromagnetic material interposed between a fixed ferromagnetic material and a variable ferromagnetic material. The fixed ferromagnetic material may have a magnetic moment which is relatively fixed because of the material's high coercivity. The non-ferromagnetic material may have no magnetic moment. The variable ferromagnetic material may have a coercivity which allows its magnetic moment to switch directions in the presence of a magnetic field. The variable ferromagnetic material may be placed within a magnetic field produced by a magnetic source. This magnetic field may determine the direction of the variable ferromagnetic material's magnetic moment.

An injection circuit may be coupled to the fixed ferromagnetic material and the non-ferromagnetic material. The injection circuit may force electrons into the fixed ferromagnetic material. The injected electrons may force other electrons out of the fixed ferromagnetic material and into the non-ferromagnetic material. Excess electrons in the non-ferromagnetic material may then flow out into the remainder of the injection circuit.

The electrons injected into the non-ferromagnetic material from the fixed ferromagnetic material can create a magnetic non-equilibrium in the non-ferromagnetic material. The magnetic non-equilibrium may create an electrical interaction between the non-ferromagnetic material and the variable ferromagnetic material. The amount of electrical interaction may depend on the direction of the magnetic moment of the variable ferromagnetic material relative to the magnetic moment of the fixed ferromagnetic material. This electrical interaction can be measured by a sensing circuit coupled to the non-ferromagnetic material and the variable ferromagnetic material. The sensing circuit measures the electrical interaction and produces an electrical signal based upon that interaction.

In one embodiment, the variable ferromagnetic material is placed within a gap in a magnetic flux guide. The magnetic flux guide channels flux from a magnetic source material through the flux guide and across any openings within the flux guide. Thus, the magnetic flux guide channels flux from the magnetic source material through the variable ferromagnetic material.

In other embodiments of the present invention, the variable ferromagnetic material is placed proximate to the magnetic source material. The magnetic source material then changes the magnetic moment of the variable ferromagnetic material directly.

The magnetic transducers may utilize non-equilibrium magnetization caused by current flow from a ferromagnetic material to a non-ferromagnetic material.

Embodiments of the invention will now be described by way of example with reference to the accompanying drawings, in which:-

Figure 1 is a block diagram of a system which both converts a magnetic signal to an electrical signal and which utilizes the electrical signal.

Figure 2 is a block diagram of the transducer and magnetic field source of Figure 1.

Figure 3 is a diagram of one embodiment of the transducer of the present invention.

Figure 4 is an exploded diagram of a portion of the transducer of Figure 3.

Figure 5 shows another embodiment of the magnetic source and transducer of the present invention.

Figure 6 is another embodiment of the transducer and magnetic source for the present invention.

Figure 7 is one embodiment of the sensing circuit in the transducer of the present invention.

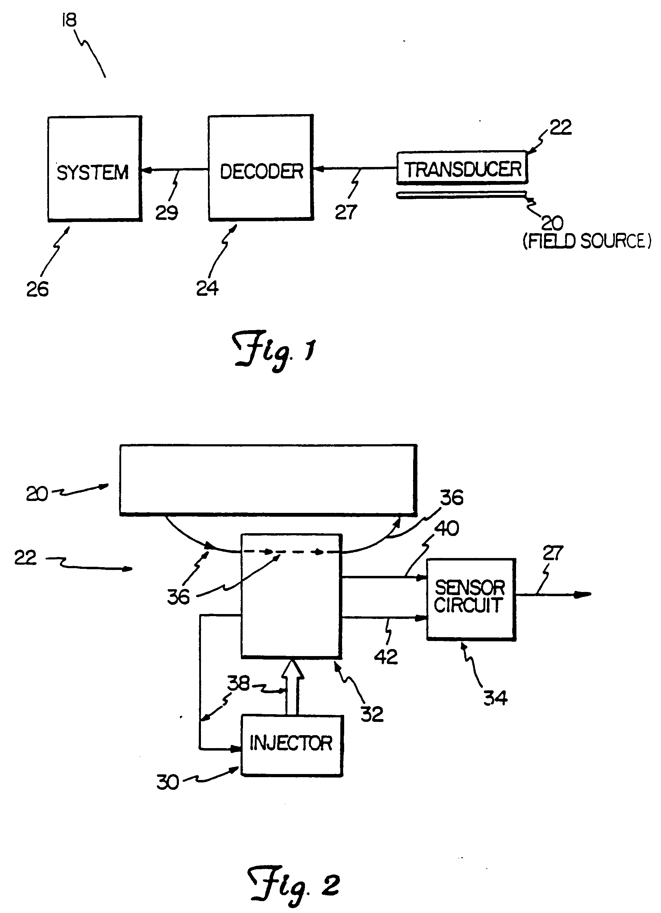

Figure 1 is a block diagram of utilization system 18, which both converts a magnetic signal into an electrical signal and utilizes that electrical signal. Utilization system 18 includes magnetic field source 20, transducer 22, decoder 24 and system 26. Magnetic field source 20 and transducer 22 are positioned proximate to one another and magnetic field source 20 provides magnetic flux to transducer 22. Typically, the magnetic flux from magnetic field source 20 varies so as to produce a meaningful signal.

Transducer 22 is coupled to decoder 24. Transducer 22 intersects magnetic flux produced by magnetic field source 20 and creates an electrical signal 27 based upon the magnetic flux. Transducer 22 provides electrical signal 27 to decoder 24.

Decoder 24 is coupled to both transducer 22 and system 26. Decoder 24 receives electrical signal 27 from transducer 22 and decodes the signal to produce a decoded signal 29. System 26 receives decoded signal 29 from decoder 24. System 26 utilizes decoded signal 29 to produce an output based upon the signals read from magnetic field source 20. For example, system 26 can produce visual images, audio signals, or computer data or programs.

Figure 2 is a block diagram of magnetic source 20 and transducer 22 of Figure 1. Transducer 22 comprises injector 30, spin detector 32 and sensor circuit 34. Injector 30 is coupled to spin detector 32 and provides spin detector 32 with injector current 38. Spin detector 32 is coupled to injector 30 and to sensor circuit 34 and is positioned proximate to magnetic source 20. Magnetic flux 36 from magnetic source 20 passes through a portion of spin detector 32. Spin detector 32 receives electrons from injector 30 through injection current 38. These electrons produce an electrical value within spin detector 32 which changes depending on the direction of magnetic flux 36. Spin detector 32 produces ground signal 40 and sensor signal 42 based upon the electrical value.

Sensing circuit 34 is coupled to spin detector 32 and receives ground signal 40 and sensor signal 42 from spin detector 32. Sensor circuit 34 senses the value of ground signal 40 and sensor signal 42 and produces electrical signal 27 based upon the value of ground signal 40 and sensor signal 42.

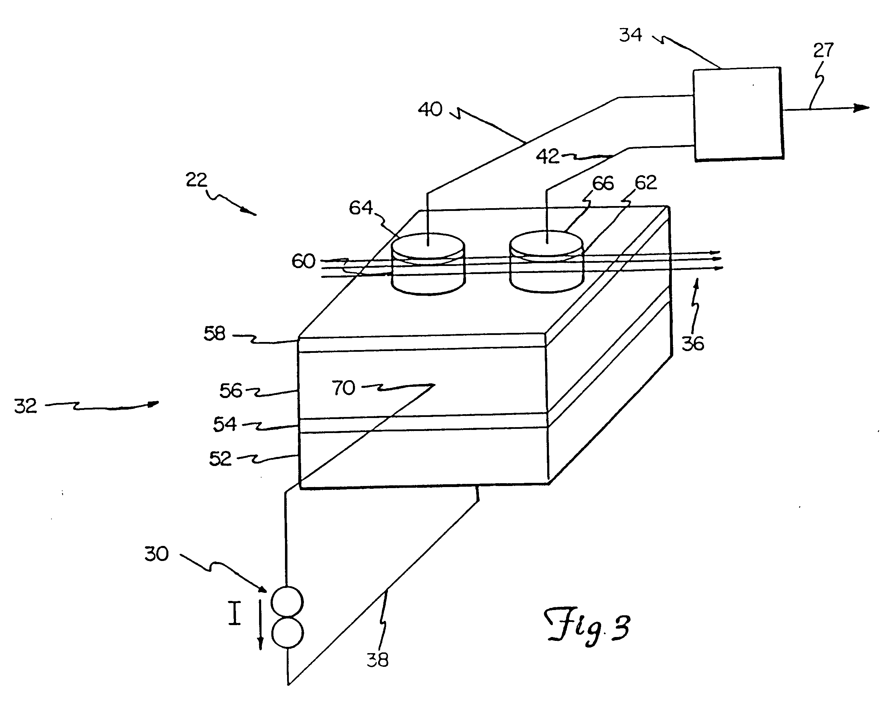

Figure 3 is a diagram of transducer 22. Transducer 22 comprises injector 30, spin detector 32 and sensor circuit 34 as in Figure 2. Spin detector 32 comprises fixed ferromagnet 52, insulator 54, non-ferromagnet 56, top insulator 58, ground sample 60, top ferromagnet 62, ground contact 64, and top ferro contact 66.

Fixed ferromagnet 52 is coupled to injector 30 and receives injector current 38 from injector 30. It has a width and length between 10 nm and 10,000 nm. It has a thickness between 1 nm and 1,000 nm. The width and length define a top and bottom surface. The top surface is in contact with insulator 54 and with non-ferromagnet 56 through openings in insulator 54. The openings in insulator 54 are discussed below. Fixed ferromagnet 52 has a fixed magnetic moment which lies parallel to the top and bottom surfaces. It is a single domain ferromagnet such that each individual magnetic moment is in the same direction as the aggregate magnetic moment. In some embodiments, it is composed of a permalloy of Niₓ Fe₁₀₀₋ₓ where x is between 20 and 90.

Injector 30 provides injector current 38 to flow through fixed ferromagnet 52 perpendicular to the top and bottom surfaces. Fixed ferromagnet 52 accepts electrons with random spin values from injector 30. However, it only releases electrons with uniform quantum spin values. Injector current 38 is between .01 mA and 1,000 mA.

Insulator 54 is in contact with fixed ferromagnet 52 and non-ferromagnet 56. It has a width and length comparable to fixed ferromagnet 52 and a thickness between .1 nm and 1,000 nm. Insulator 54 prevents the flow of current between fixed ferromagnet 52 and non-ferromagnet 56 except through two openings. These openings are described further below.

Non-ferromagnet 56 is in contact with fixed ferromagnet 52, insulator 54, top insulator 58, ground sample 60 and top ferromagnet 62. In addition, non-ferromagnet 56 is coupled to injector 30 at contact point 70. It has a width and length comparable to fixed ferromagnet 52 and insulator 54 and a thickness between .1 nm and 1,000 nm.

Non-ferromagnet 56 receives electrons with uniform quantum spin values from fixed ferromagnet 52 and releases electrons to injector 30 with either spin value. Those electrons are released to injector 30 at contact point 70. This electron flow creates a magnetic non-equilibrium due to an excess of electrons with a particular spin accumulating within non-ferromagnet 56.

Top insulator 58 is in contact with non-ferromagnet 56, ground sample 60 and top ferromagnet 62. It has a length and width comparable to non-ferromagnet 56 and a thickness between .1 nm and 1,000 nm. It only allows current flow between non-ferromagnet 56 and ground sample 60 through a small opening in top insulator 58 near the center of ground sample 60. Likewise, it only allows current flow between non-ferromagnet 56 and top ferromagnet 62 through a small opening in top insulator 58 near the center of top ferromagnet 62.

Ground sample 60 is in contact with top insulator 58, non-ferromagnet 56 and ground contact 64. In one preferred embodiment, it is a disk with a diameter and thickness between .1 nm and 1,000 nm. In other embodiments, it is a block with similar dimensions. Ground sample 60 is in equilibrium both electrically and magnetically with non-ferromagnet 56 because it is made from the same material as non-ferromagnet 56. It provides a base measurement which sensor circuit 34 uses to determine the electrical interaction between top ferromagnet 62 and non-ferromagnet 56. Magnetic flux 36 passes through ground sample 60 but does not affect it since it is non-ferromagnetic.

Top ferromagnet 62 is in contact with non-ferromagnet 56, insulator 58 and top ferro contact 66. In one preferred embodiment, it is a disk with a diameter and thickness between .1 nm and 1,000 nm. In other embodiments, it is a block with similar dimensions. In still other embodiments, it is a long and narrow block with the long side running parallel to the direction of the magnetic field. Top ferromagnet 62 is penetrated by magnetic flux 36. Magnetic flux 36 causes the aggregate magnetic moment of top ferromagnet 62 to match the direction of magnetic flux 36.

Top ferromagnet 62 is single domain and is only able to accept electrons with spin values that point in the opposite direction from its magnetic moment. Therefore, the electrons in non-ferromagnet 56 with a spin value in the same direction as the magnetic moment of top ferromagnet 62 will not experience a potential drop by crossing from non-ferromagnet 56 into top ferromagnet 62. On the other hand, electrons in non-ferromagnet 56 with a spin value in the opposite direction from the magnetic moment of top ferromagnet 62 will experience a potential drop travelling from non-ferromagnet 56 into ferromagnet 62. Thus, by measuring the potential between top ferromagnet 62 and non-ferromagnet 56 or by measuring the current flow from non-ferromagnet 56 into top ferromagnet 62, the direction of the magnetic moment of top ferromagnet 62 is determined. Since the direction of the magnetic moment matches the direction of the external field, the direction of the field is also determined.

In one embodiment, top ferromagnet 62 is composed of a permalloy of Niₓ Fe₁₀₀₋ₓ where x is between 20 and 90. In other embodiments, top ferromagnet 62 is composed of Co. In all cases, the composition, size and shape of top ferromagnet 62 results in a lower coercivity than fixed ferromagnet 52.

Ground contact 64 is in contact with ground sample 60 and sensing circuit 34. Ground contact 64 provides a contact to ground sample 60 and allows accurate measurement of the potential of ground sample 60 or the current flow into or out of ground sample 60.

Top ferro contact 66 is in contact with top ferromagnet 62 and sensing circuit 34. Top ferro contact 66 provides a uniform contact with top ferromagnet 62 and provides an accurate measurement of either the potential of top ferromagnet 62 or the current flowing into or out of top ferromagnet 62. In other embodiments, ground sample 60 and top ferromagnet 62 are coupled directly to sensing circuit 34.

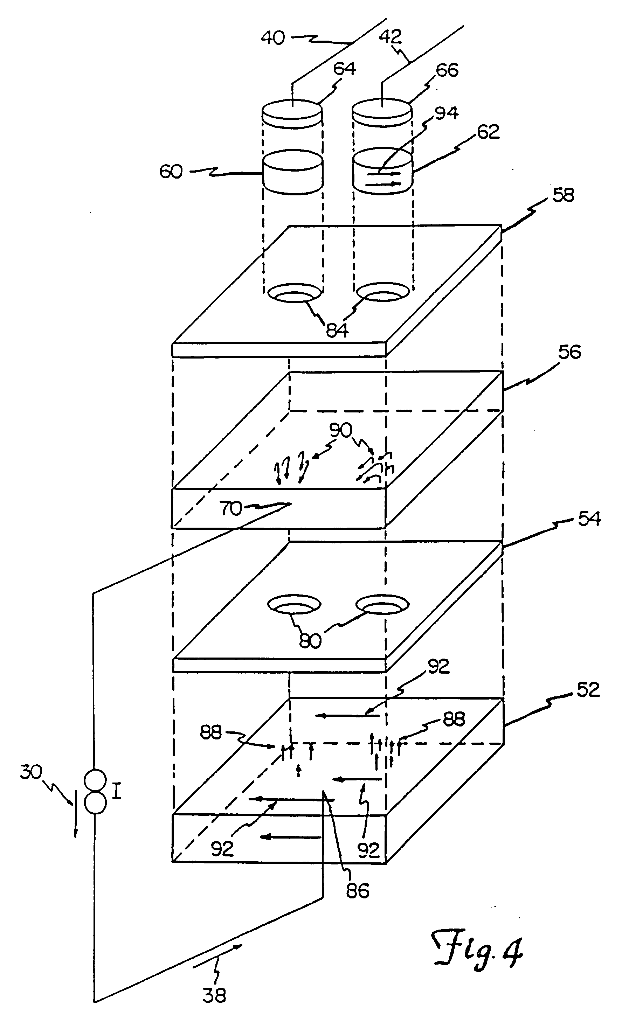

Figure 4 is an exploded diagram of spin detector 32 and injector 30 of Figure 3. Spin detector 32 once again comprises fixed ferromagnet 52, insulator 54, non-ferromagnet 56, top insulator 58, ground sample 60, top ferromagnet 62, ground contact 64 and top ferro contact 66.

In Figure 4, injector 30 contacts fixed ferromagnet 52 at contact point 86. At contact point 86, electrons flow from injector 30 into fixed ferromagnet 52 and diffuse throughout fixed ferromagnet 52.

Fixed ferromagnet 52 of Figure 4 contains fixed magnetic moment 92. Fixed magnetic moment 92 results from there being more electrons with one quantum spin value than electrons with the other quantum spin value. This occurs because the energy band for one of the quantum spin values is lower than the energy band of the other. The lower energy band fills with electrons before the higher energy band resulting in more electrons in the lower energy band. The direction of fixed magnetic moment 92 matches the direction of spin of the electrons in the lower energy band. It follows that electrons in the higher energy band have a spin direction which points in the opposite direction from fixed magnetic moment 92. These higher energy band electrons are electrical current carriers for fixed ferromagnet 52. Therefore, of the electrons which leave fixed ferromagnet 52 almost all have the same quantum spin value which points in the opposite direction from fixed magnetic moment 92.

The path of electrons out of fixed ferromagnet 52 is shown as electron path 88. Electron path 88 demonstrates that electrons only flow out of fixed ferromagnet 52 at selected areas where fixed ferromagnet 52 contacts non-ferromagnet 56. Thus, all of the electrons which leave fixed ferromagnet 52 leave along electron path 88 with a quantum spin value which points in the opposite direction from magnetic moment 92.

Insulator 54 is a continuous surface except for openings 80. Fixed ferromagnet 52 and non-ferromagnet 56 make contact through openings 80 providing electron path 88. As described above, a current flows along electron path 88 from fixed ferromagnet 52 into non-ferromagnet 56 through openings 80 in insulator 54.

Non-ferromagnet 56 receives electrons with uniform spin values from fixed ferromagnet 52 through openings 80. Electron path 90 depicts the path of electrons passing through non-ferromagnet 56 from fixed ferromagnet 52 to contact point 70. In other embodiments, contact point 70 is located between openings 84 in top insulator 58 described below. In these other embodiments, an additional opening in top insulator 58 allows injector 30 to make contact with contact point 70. Electron path 90 shows that electrons only enter non-ferromagnet 56 through two areas correlating to openings 80 in insulator 54 where non-ferromagnet 56 contacts fixed ferromagnet 52.

The electrons from fixed ferromagnet 52 retain their quantum spin value as they enter non-ferromagnet 56. This increases the number of electrons with this quantum spin value in non-ferromagnet 56. To accommodate this increase, these electrons must occupy energy states at higher energy levels than existing electrons in non-ferromagnet 56. This not only makes these electrons more available for conduction but also creates a magnetic non-equilibrium. As the electrons move along electron path 90 some experience events which cause them to change quantum spin values. Thus, there is a larger magnetic non-equilibrium at openings 80 than at contact point 70.

Top insulator 58 lies between non-ferromagnet 56 and both ground sample 60 and top ferromagnet 62. Top insulator 58 is a continuous surface except for openings 84. Openings 84 lie directly above openings 80 in insulator 54 and directly beneath ground sample 60 and top ferromagnet 62. Openings 84 allow non-ferromagnet 56 to contact ground sample 60 and top ferromagnet 62.

In other embodiments openings 84 are not directly over openings 80. However, in all embodiments openings 84 should preferably be positioned so that ground sample 60 senses the same magnetic non-equilibrium in non-ferromagnet 56 as top ferromagnet 62 senses.

Ground sample 60 is in contact with top insulator 58 and lies directly above one of the openings 84. Ground sample 60 is in direct contact with non-ferromagnet 56. Further, ground sample 60 is made of the same material as non-ferromagnet 56. Because of this, ground sample 60 is at the same potential as non-ferromagnet 56. Ground contact 64 is connected to ground sample 60 and sensor 34. Ground contact 64 carries ground signal 40 which is an electrical value of ground sample 60.

One surface of top ferromagnet 62 is in contact with top ferro contact 66. A second surface of top ferromagnet 62 is in contact with insulator 58 and with non-ferromagnet 56 through one of the openings 84 in top insulator 58. Top ferromagnet 62 has a magnetic moment 94 which lies parallel to the plane of this second surface.

Like magnetic moment 92 of fixed ferromagnet 52, magnetic moment 94 results from there being more electrons with one quantum spin value than electrons with the other value. This occurs in top ferromagnet 62 because the energy band for one quantum spin value is lower than the energy band for the other. The lower energy band is completely filled in top ferromagnet 62 but the higher energy band is not filled. This results in more electrons having the lower energy quantum spin value than the higher energy spin value. The direction of magnetic moment 94 matches the direction of the spin of the lower filled energy band and points in the opposite direction from the partially filled higher energy band.

Since the lower energy band is filled, top ferromagnet 62 has no available energy states for electrons with quantum spin values which match the lower energy band. Therefore, it can not accept electrons with that spin value. However, it can accept electrons with the opposite spin value into the higher energy band.

As discussed above, non-ferromagnet 56 has been injected with electrons which have a spin value that points in the opposite direction from magnetic moment 92. These injected electrons are in energy states above the energy level needed for conduction into top-ferromagnet 62. These electrons produce an electric potential between non-ferromagnet 56 and top ferromagnet 62 only if top ferromagnet 62 has an eligible energy state. To be an eligible energy state, the energy state must have the same spin value as the electron above the conduction level in non-ferromagnet 56. The energy state must also be unoccupied. If there are no eligible energy states, the electron in non-ferromagnet 56 can not conduct into top ferromagnet 62 and the two materials are at the same electrical potential. However, if there is an eligible energy state in top ferromagnet 62, the electrons are at a higher electrical potential in non-ferromagnet 56 than in top ferromagnet 62.

Since the only open energy states in top ferromagnet 62 are in the partially filled higher energy band, the spin value of this energy band must match the spin value of the electrons above the conduction level for an electric potential to develop. If they do match, an electric potential develops between the two materials. If they do not match, no electrical potential develops.

Since the spin value of the higher energy level in top ferromagnet 62 points in the opposite direction from magnetic moment 94, an electrical potential develops when the electrons above the conduction level in non-ferromagnet 56 point in the opposite direction from magnetic moment 94. Since these electrons point in the opposite direction from magnetic moment 92, an electrical potential develops when magnetic moment 92 and magnetic moment 94 point in the same direction. There is no electrical potential between non-ferromagnet 56 and top ferromagnet 62 when magnetic moment 92 and magnetic moment 94 point in opposite directions.

Magnetic moment 94 is not coupled to magnetic moment 92 of fixed ferromagnet 52. In other words, magnetic moment 94 of top ferromagnet 62 may switch directions independently of magnetic moment 92 of fixed ferromagnet 52. The non-coupling between top ferromagnet 62 and fixed ferromagnet 52 is caused by the distance between top ferromagnet 62 and fixed ferromagnet 52.

Top ferro contact 66 is in contact with top ferromagnet 62 and sensor 34. Top ferro contact 66 provides sensor signal 42 to sensor 34. Sensor signal 42 is a representation of an electrical value of top ferromagnet 62. This electrical value is typically either an electrical potential or a current. The potential difference between sensor signal 42 and ground signal 40 or the current through sensor signal 42 indicates the direction of magnetic moment 94. A high potential difference or current indicates that it points in the same direction as magnetic moment 92. A small potential difference indicates that it points in the opposite direction.

Magnetic moment 94 changes direction to match the direction of an external magnetic field. The change in direction is very abrupt and results in an abrupt change in the potential between non-ferromagnet 56 and top ferromagnet 62. The abruptness of the change results in a high signal to noise ratio for the measured potential and provides a more digital than analog signal.

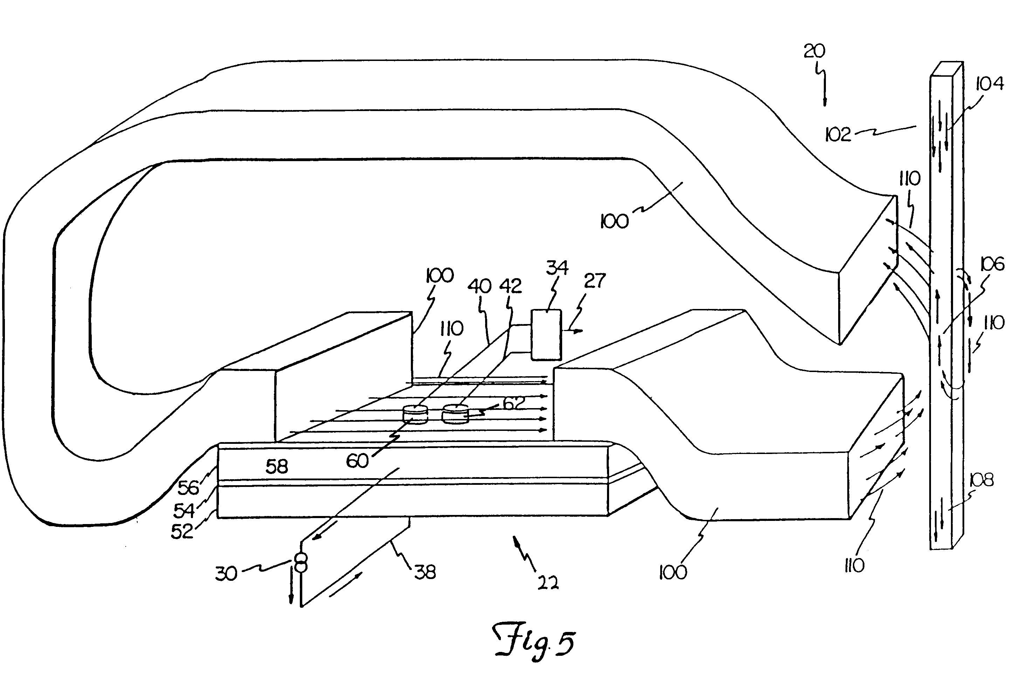

Figure 5 is a diagram of one embodiment of magnetic source 20 and transducer 22. Transducer 22 is identical in form and operation to transducer 22 of Figures 3 and 4 described above. Magnetic source 20 comprises magnetic flux guide 100, magnetic surface 102 and magnetic domains 104, 106 and 108.

Magnetic domains 104, 106 and 108 are areas on magnetic surface 102 which are magnetized in one of two directions. Further, magnetic domains 104, 106 and 108 produce magnetic flux 110. Magnetic flux 110 exists in the area surrounding magnetic surface 102. The direction of magnetic flux 110 is localized around each magnetic domain and is controlled by the direction of the magnetic moment of an individual domain.

Magnetic flux guide 100 is divided into two pieces with two substantial gaps between the pieces. Transducer 22 lies within one of the gaps and part of magnetic surface 102 lies within the other gap. The magnetic flux 110 produced by the magnetic domain residing within the gap of magnetic flux guide 100 radiates into the flux guide. That magnetic flux is channelled through magnetic flux guide 100 and across the gap in magnetic flux guide 100 where transducer 22 resides. As such, magnetic flux 110 is channelled through ground sample 60 and top ferromagnet 62. Magnetic flux 110 sets magnetic moment 94 of top ferromagnet 62 so that the direction of magnetic moment 94 matches the direction of magnetic flux 110. As magnetic flux guide 100 moves to different areas of magnetic surface 102, magnetic flux 110 changes directions. These changes in direction cause changes in the direction of magnetic moment 94 of top ferromagnet 62. As discussed previously, a change in the direction of magnetic moment 94 may be sensed as a change in potential or current by sensing circuit 34.

In one embodiment, audio or visual information is recorded on magnetic surface 102 by differentially magnetizing different areas of magnetic surface 102. By changing the location of magnetic flux guide 100 along magnetic surface 102, magnetic transducer 22 is able to convert the stored magnetic signal into an electrical signal through the processes described above.

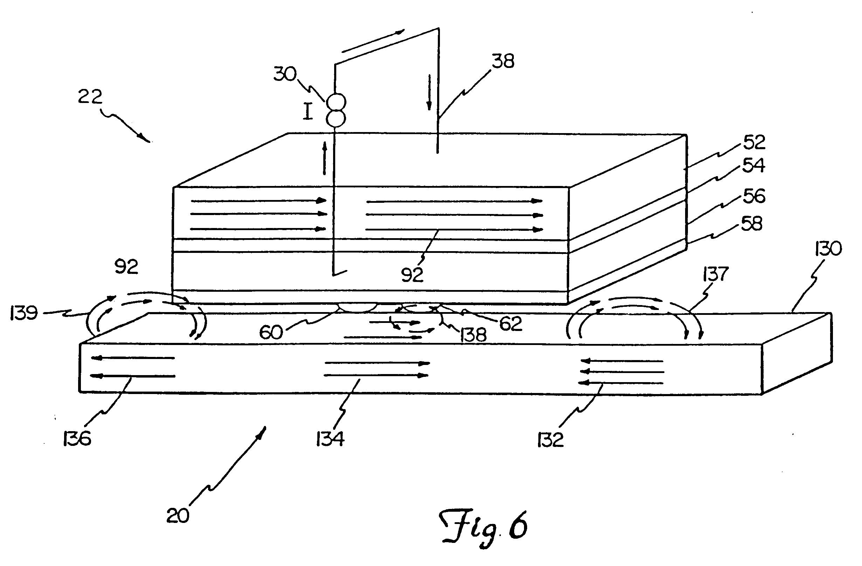

Figure 6 is another embodiment of the present invention. In Figure 6, the flux guide has been removed and top ferromagnet 62 of transducer 22 has been placed directly proximate to magnetic surface 130. Magnetic surface 130 comprises magnetic domain areas 132, 134 and 136. Magnetic domain areas 132, 134 and 136 produce magnetic flux 137, 138 and 139 which exists externally to magnetic surface 130.

Top ferromagnet 62 and ground sample 60 are placed close enough to magnetic surface 130 that they intersect magnetic flux 137, 138 and 139 as they pass near magnetic domain areas 132, 134 and 136 respectively.

Transducer 22 of Figure 6 comprises the same components as transducer 22 of Figures 3, 4 and 5 and operates in a manner similar to that described above for transducer 22. As top ferromagnet 62 passes from one domain area to another, its magnetic moment changes depending on the direction of flux from the domain area it is currently over. As in the magnetic surface for Figure 5, data, audio information or visual information is stored on magnetic surface 130 by changing the magnetic moment of different areas of magnetic surface 130, previously referred to as magnetic domain areas. Thus, as top ferromagnet 62 moves relative to magnetic surface 130, it is able to transduce the recorded magnetic signal into an electrical signal through the processes described above. The relative movement of transducer 22 is accomplished with a transducer moving apparatus not shown or with a magnetic surface moving apparatus not shown.

In one preferred embodiment, magnetic surface 130 is a magnetic disk and magnetic transducer 22 is a magnetic read head which flies above the magnetic disk on an air bearing cushion. In other embodiments, magnetic surface 130 is a magnetic tape for recording information.

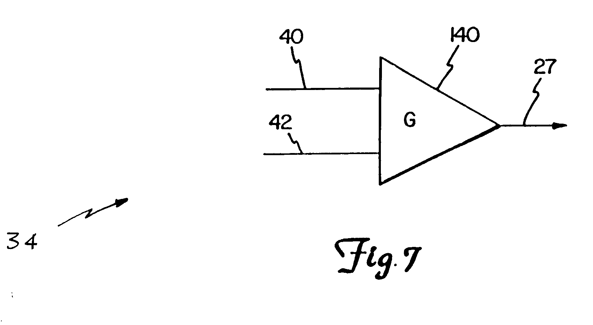

Figure 7 is a diagram of one embodiment of sensor circuit 34. In Figure 7, sensor circuit 34 is comprised of a differential voltage gain amplifier 140. Differential gain amplifier 140 receives sensor signal 42 and ground signal 40 and produces output signal 27. Differential voltage gain amplifier 140 amplifies the difference in voltage between sensor signal 42 and ground signal 40. This amplified signal is output signal 27.

In other embodiments, sensor circuit 34 is a transconductance amplifier which produces an amplified voltage based upon the current running through sensor signal 42 and ground signal 40.

Although the present invention has been described with reference to preferred embodiments, workers skilled in the art will recognize that changes may be made in form and detail without departing from the spirit and scope of the invention.

## Claims

1. A transducer (22) comprising ferromagnetic material (52, 62) and non-ferromagnetic material (56), characterised in that the transducer is arranged such that it senses information on a storage medium (20) by using a magnetic non-equilibrium caused by current flow (38) between ferromagnetic material (52) and non-ferromagnetic material (56).

2. A transducer (22) of claim 1, wherein further ferromagnetic material (62) is provided, the non-ferromagnetic (56) separating the ferromagnetic material (52) and the further ferromagnetic material (62), and sensing means (34) is provided which detects the change in magnetic characteristics of the further ferromagnetic material (62) due to a magnetic source (36) acting thereon.

3. A transducer (22) for converting a magnetic signal (36) into an electric signal (27), the transducer characterised by comprising:
a first ferromagnetic material (62) having a magnetic moment with a direction;
a non-ferromagnetic material (56), having a first side and a second side, the first side coupled to the first ferromagnetic material (62);
a second ferromagnetic material (52) coupled to the second side of the non-ferromagnetic material (56), the second ferromagnetic material having a magnetic moment;
injection means (30), coupled to the second ferromagnetic material (52) and the non-ferromagnetic material (56) for injecting electrons from the second ferromagnetic material (52) into the non-ferromagnetic material (56); and
sensing means (34), coupled to the non-ferromagnetic material (56) and the first ferromagnetic material (62) for sensing the direction of the magnetic moment of the first ferromagnetic material (62) caused by a magnetic signal (36) provided by a magnetic source proximate to the first ferromagnetic material (62), and creating an electrical signal (27) based on that direction.

4. The transducer of claim 1, 2 or 3 wherein injected electrons retain their quantum spin value as they enter the non-ferromagnetic material (56) creating a spin imbalance in the non-ferromagnetic material.

5. The transducer of any one of claims 1 to 4 wherein some of injected electrons change their quantum spin value as they move through the non-ferromagnetic material (56) creating a spatially decaying spin imbalance in the non-ferromagnetic material.

6. The transducer of any one of claims 1 to 5 wherein the magnetic signal (36) originates from a magnetic disk in a computer disk drive and the transducer (22) is a transducer for a computer disk drive.

7. The transducer of any one of claims 2 to 6 wherein a flux guide (100) is provided to transmit magnetic flux from the magnetic source (36).

8. The transducer of any one of claims 3 to 7 wherein the sensing means (34) is coupled to the non-ferromagnetic material (56) through a ground sample (60), the ground sample comprising the same material as the non-ferromagnetic material (56).

9. The transducer of any one of claims 3 to 8 further comprising a first insulating layer (58) between the non-ferromagnetic material (56) and the first ferromagnetic material (62) and ground sample (60), the first insulating layer having at least one opening (84).

10. The transducer of claim 5 wherein the spin imbalance in the non-ferromagnetic material (56) near the first ferromagnetic material is the same as the spin imbalance in the non-ferromagnetic material near the ground sample.

11. The transducer of any one of claims 3 to 10 wherein the second ferromagnet (52) has a larger surface area than the first ferromagnet (62).

12. The transducer of any one of claims 3 to 11 wherein the first ferromagnet (62) and the second ferromagnet (62) each have a coercivity, the coercivity of the second ferromagnet (62) being greater than the coercivity of the first ferromagnet (52).

13. The transducer of any one of claims 3 to 12 further comprising a second insulating layer (54) between the second ferromagnetic material (52) and the non-ferromagnetic material (56) , the second insulating layer having at least one opening (80).

14. An apparatus for converting a magnetic signal (36) into an electric signal (27), the apparatus characterised by comprising:
an injection material (52), accepting electrons without uniform quantum spin values but releasing electrons with uniform quantum spin values;
a storage material (56), coupled to the injection material (52), the storage material receiving electrons with uniform quantum spin values from the injection material, but releasing electrons without uniform quantum spin values, the exchange of electrons creating a magnetic imbalance in the storage material;
a sensing material (62), coupled to the storage material (56) but separated from the injection material (52), the sensing material residing within the magnetic signal (36), the sensing material's ability to accept electrons from the storage material (56) changing with changes in the direction of the magnetic signal (36);
injection means (30) coupled to the injection material (52) and the storage material (56) for injecting electrons into the injection material and accepting electrons from the storage material; and
sensing means (34) coupled to the storage material (56) and the injection material (52) for sensing the changes in the sensing material's (62) ability to accept electrons from the storage material.

15. A magnetic field sensor (22), for sensing an external magnetic field (36), the magnetic field sensor characterised by comprising:
spin injection means (30, 52, 54, 56), producing electrons with quantum spin values which are substantially in one direction; and
sensing means (34, 62, 66), coupled to the spin injection means and having electrons injected into it by the spin injection means, the sensing means responding to the external magnetic field and the direction of the quantum spin of the injected electrons to produce an electrical signal (27).
